# EUROPÄISCHE PATENTSCHRIFT

(11) **EP 0 907 880 B1**
(45) Veröffentlichungstag und Bekanntmachung des Hinweises auf die Patenterteilung: **27.03.2002**
(21) Anmeldenummer: 97930331.0
(22) Anmeldetag: 17.06.1997
(51) Int. Cl.: G01L 9/00

(54) **AUF DER BESTÜCKUNGSOBERFLÄCHE EINER LEITERPLATTE MONTIERBARES DRUCKSENSOR-BAUELEMENT**
PRESSURE SENSOR COMPONENT MOUNTED ON THE INSERTION SURFACE OF A CIRCUIT BOARD
COMPOSANT A CAPTEUR DE PRESSION POUVANT ETRE MONTE SUR LA SURFACE D'IMPLANTATION D'UNE CARTE DE CIRCUITS

(30) Priorität: 28.06.1996 DE 19626086
(43) Veröffentlichungstag der Anmeldung: 14.04.1999
(73) Patentinhaber: Infineon Technologies AG, 81669 München (DE)
(72) Erfinder: WINTERER, Jürgen, D-90451 Nürnberg (DE); AUBURGER, Albert, D-93128 Regenstauf (DE)
(86) Internationale Anmeldenummer: DE9701232
(87) Internationale Veröffentlichungsnummer: WO9800690

(56) Entgegenhaltungen:
- DE-A- 4 017 697
- PATENT ABSTRACTS OF JAPAN vol. 095, no. 008, 29.September 1995 & JP 07 113706 A (FUJI ELECTRIC CO LTD), 2.Mai 1995,
- PATENT ABSTRACTS OF JAPAN vol. 096, no. 005, 31.Mai 1996 & JP 08 017870 A (HITACHI LTD;OTHERS: 01), 19.Januar 1996,
- ADAMS V J: "EPOXY PACKAGE FOR PRESSURE SENSOR" MOTOROLA TECHNICAL DEVELOPMENTS, Bd. 12, Seite 154 XP000229319
- PATENT ABSTRACTS OF JAPAN vol. 017, no. 160 (E-1342), 29.März 1993 & JP 04 323909 A (TOYO COMMUN EQUIP CO LTD), 13.November 1992,
- PATENT ABSTRACTS OF JAPAN vol. 016, no. 386 (P-1404), 18.August 1992 & JP 04 125438 A (HITACHI LTD), 24.April 1992,

## Beschreibung

Die Erfindung bezieht sich auf ein auf der Bestuckungsoberfläche einer Leiterplatte montierbares Drucksensor-Bauelement mit einem eine annähernd ebene Chipträgerfläche aufweisenden Chipträger, vorzugsweise aus elektrisch isolierendem Material, auf welcher Chipträgerfläche ein Halbleiterchip mit einem Drucksensor befestigt ist, und mit den Chipträger durchsetzenden und elektrisch mit dem Halbleiterchip verbundenen Elektrodenanschlüssen mit einer oberflächenmontierbaren Anordnung.

Die Verwendung von oberflächenmontierbaren Halbleiter-Bauelementgehäusen in SMD-Anordnung (SMD = Surface Mounted Design) ermöglicht eine kostengünstige platzsparende Kontaktierung auf einer Anwenderplatine. Dies gilt auch für Sensor-Bauelemente, die zur Druckmessung verwendet werden. Bei dieser Montageform werden die Bauelementanschlüsse nicht mehr in Löcher der Leiterplatte wie bei der Einsteckmontage hineingesteckt, sondern auf Anschlußflecken auf der Leiterplatte aufgesetzt und dort verlötet. Bauelemente für die Oberflächenmontage können kleiner sein als für die Einsteckmontage, da nicht mehr Loch- und Lötaugendurchmesser der Leiterplatte das Rastermaß der Anschlüsse bestimmen. Weiterhin entfallen auf der Leiterplatte die nur zur Bestückung notwendigen Löcher, wobei die lediglich noch zur Durchkontaktierung benötigten Löcher so klein wie technologisch möglich ausgeführt werden können. Da dazu noch eine doppelseitige Bestückung der Leiterplatte möglich ist, kann durch die Oberflächenmontage eine beträchtliche Platzeinsparung und erhebliche Kostensenkung erzielt werden. Eine besonders geringe Bauhöhe des elektronisches Bauelementes ergibt sich hierbei, wenn die den Chipträger durchsetzenden und elektrisch mit dem Halbleiterchip verbundenen Elektrodenanschlüsse in der Form von nach wenigstens zwei Seiten des Chipträgers herausgeführten Anschlußbeinchen ausgebildet sind, die zu kurzen schwingenförmigen Anschlußstummeln gebogen und geschnitten sind.

Zur Messung von Drücken muß das zu messende Medium an den Sensor herangeführt bzw. der in dem Medium herrschende Druck an den Sensor übertragen werden. Zu diesem Zweck ist der Drucksensor in einem einseitig offenen Bauelementgehäuse angeordnet, so daß die sensitive Chipfläche des Drucksensors unmittelbar mit dem zu messenden Medium in Berührung gelangen kann. Bei dieser Anordnung besteht der Nachteil, daß der empfindliche Chipsensor, aber auch die sonstigen Bestandteile des einseitig offenen Drucksensor-Bauelements schädlichen Umwelteinflüssen ausgesetzt ist, so daß die Gefahr einer Korrosion der Bestandteile des Bauelements besteht, welche bis zur Zerstörung des Bauelementes führen kann.

Aus Patent Abstracts of Japan, Vol. 095, No. 008 (JP-A-0 7113706) ist ein Drucksensor bekannt, welcher innerhalb des Gehäuses ein Silikon-Gel aufweist. Das beschriebene Bauelement ist nicht für die SMD-Montage geeignet. Das Gehäuse ist mittels eines Deckels verschlossen.

Der vorliegenden Erfindung liegt die Aufgabe zugrunde, ein Drucksensor-Bauelement für die Montage auf einer Bestückungsoberfläche einer Leiterplatte zur Verfügung zu stellen, wobei das Drucksensor-Bauelement vorzugsweise ein einseitig offenes Gehäuse mit einem Chipträger besitzt, welches Drucksensor-Bauelement derart ausgebildet ist, daß eine Korrosion der den Unwelteinflüssen ausgesetzten Bestandteile mit der Gefahr einer Zerstörung des Bauelements sicher vermieden werden kann.

Diese Aufgabe wird durch ein Drucksensor-Bauelement nach Anspruch 1 gelöst.

Es ist vorgesehen, daß der Chipträger mit einem den Halbleiterchip vollständig überdeckenden, fließfähigen Füllmittel befüllt ist.

Als Schutz gegen Umwelteinflüsse wird ein fließfähiges Füllmittels verwendet, welches den sensitiven Halbleiterchip vollständig bedeckt. Das Füllmittel ist fließfähig und somit hinreichend elastisch bzw. flexibel genug, um Drücke ohne Verfälschung der Meßergebnisse an den Drucksensor weiterzugeben. Damit wird den beiden Forderungen nach bestmöglicher Druckankopplung und Trennung des zu messenden Mediums gerecht.

Die Verwendung eines fließfähigen Füllmittels als Schutz gegen Umwelteinflüsse stellt eine kostengünstige und inlinefähige Möglichkeit der Ummantelung von Drucksensoren dar, welche in großen Stückzahlen gefertigt werden. Dabei ist eine gezielte Dosierung des fließfähigen Füllmittels sowie ein gesteuertes Formfüllungsverhalten wünschenswert. Um dies zu erreichen, ist bei einer besonders bevorzugten Ausführung der Erfindung vorgesehen, daß der Chipträger an seiner der Bestückungsoberfläche der Leiterplatte abgewandten Seite einseitig offen ausgebildet ist und die Seitenwandungen des Chipträgers mit einer auf der Innenseite durchgehend angeordneten Flußstopkante ausgestattet sind. Die Flußstopkante bewirkt einen definierten Stop der Kapillarkräfte des adhäsiven Füllmittels und verhindert auf diese Weise ein Hochsteigen des Füllmittels über die Gehäuseränder hinaus. Auf diese Weise können Verschleppungen des Füllmittels in weiteren Folgeschritten bei der Fertigung des Drucksensor-Bauelementes und die damit einhergehende Verschmutzung oder Schädigung der Fertigungswerkzeuge verhindert werden.
Das fließfähige Füllmittel kann somit auf genau definierte Weise innerhalb des Bauelementes plaziert werden, wobei auch bei einer auf dem Kopf stehenden Montage des einseitig offenen Chipträgers ein Austreten des Füllmittels sicher vermieden wird. In vorteilhafter Weise ermöglicht die Flußstopkante bei entsprechend gestalteter Anordnung auch, daß die wirksame Dicke des fließfähigen Füllmittels möglichst gering gehalten werden kann, um den unerwünschten Einfluß auf die Meßempfindlichkeit des Drucksensors im Hinblick auf die zu messenden Beschleunigungen bzw. Drücke nicht zu sehr zu verschlechtern, welche bekanntermaßen mit zunehmender Geldicke herabgesetzt wird.

Es kann weiterhin vorgesehen sein, daß das fließfähige Füllmittel des weiteren die gegenüber Korrosion anfälligen, insbesondere metallischen Bauteile des Drucksensor-Bauelementes wie insbesondere Verbindungsdrähte, Stützträger für den Halbleiterchip und dergleichen umgibt. Bei einer besonders bevorzugten Ausführung der Erfindung stellt das fließfähige Füllmittel ein Gel dar.

Die Erfindung betrifft ein Drucksensor-Bauelement für eine Oberflächenmontage auf der Bestückungsoberfläche einer Leiterplatte. In diesem Sinne ist es daher von Vorteil, wenn die den Chipträger durchsetzenden und elektrisch mit dem Halbleiterchip verbundenen Elektrodenanschlüssen in der Form von nach wenigstens einer Seite des Chipträgers herausgeführten Anschlußbeinchen ausgebildet sind, die zu kurzen schwingenförmigen Anschlußstummeln gebogen und geschnitten sind. Bevorzugte Ausgestaltungen der Erfindung ergeben sich hierzu aus den in den Unteransprüchen angegebenen Merkmalen.

In besonders bevorzugter Weise ist der Chipträger einstückig aus einem Thermoplastkunststoffmaterial hergestellt.

Weitere Merkmale, Vorteile und Zweckmäßigkeiten der Erfindung ergeben sich aus der Beschreibung eines Ausführungsbeispiels anhand der Zeichnung. Es zeigt:
- Figur 1: eine schematische Schnittansicht eines Drucksensor-Bauelementes gemäß einem Ausführungsbeispiel der Erfindung; und
- Figur 2: eine schematische Gesamtansicht des Chipträgers eines Drucksensor-Bauelementes nach dem Ausführungsbeispiel.

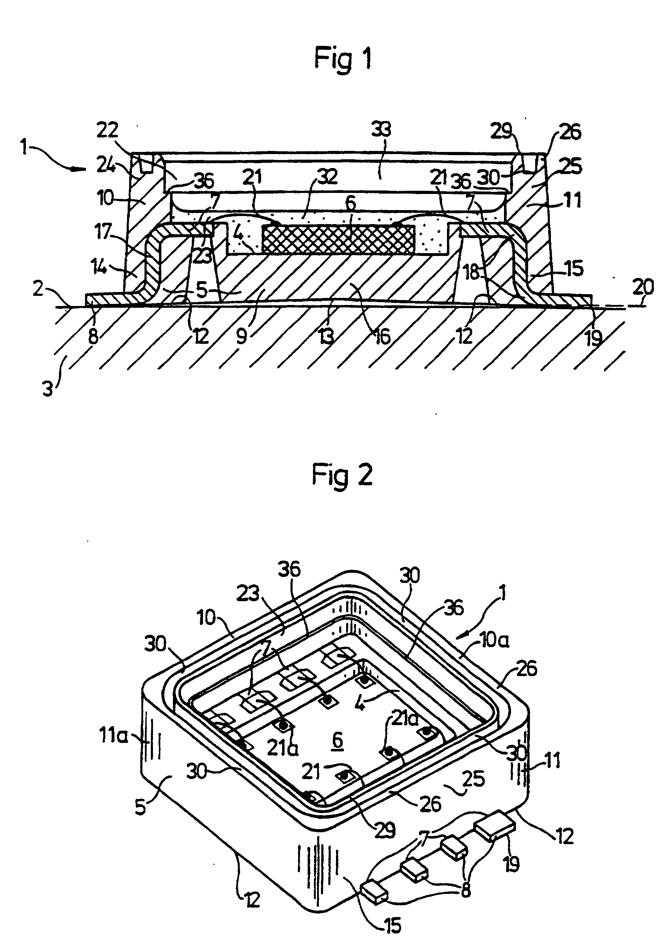

Die Figuren zeigen ein Ausführungsbeispiel eines erfindungsgemäßen Drucksensor-Bauelementes 1 für eine Oberflächenmontage auf der Bestückungsoberfläche 2 einer Leiterplatte 3. Das Drucksensor-Bauelement 1 besitzt einen eine annähernd ebene Chipträgerfläche 4 aufweisenden Chipträger 5 aus elektrisch isolierendem Kunststoffmaterial, auf welcher Chipträgerfläche 4 ein Halbleiterchip 6 mit einem integriert ausgebildeten Drucksensor und diesem zugeordnete elektronischen Schaltung befestigt ist, wobei der Drucksensor und die Schaltung in den Figuren nicht näher dargestellt sind, und den Chipträger 5 durchsetzenden und elektrisch mit dem Halbleiterchip 6 verbundenen Elektrodenanschlüssen 7, deren Enden 8 auf (nicht näher dargestellten) Anschlußflecken auf der Bestückungsoberfläche 2 der Leiterplatte 3 aufgesetzt und dort verlötet werden. Der insbesondere einstückig, vermittels eines an sich bekannten Kunststoffgießverfahrens hergestellte Chipträger 5 umfaßt ein gegenüber der Bestückungsoberfläche 2 abgehobenes Unterteil 9, auf dem der Halbleiterchip 6 abgestützt ist, sowie zu den Seiten des Unterteiles 9 angeordnete Seitenteile 10, 10a und 11, 11a, welche die seitlich abschließenden Gehäusewandungen des Drucksensorgehäuses bilden. Der Chipträger 5 ist nach der in Figur 1 im wesentlichen maßstabsgerecht dargestellten Weise derart ausgebildet, daß die der Bestükkungsoberfläche 2 der Leiterplatte 3 zugewandten äußeren Begrenzungsflächen 12, 13 des Chipträgers 5 einen von den unteren Randbereichen 14, 15 zum Mittenbereich 16 des Chipträgers 5 stetig zunehmenden Abstand zur Bestückungsoberfläche 2 der Leiterplatte 3 aufweisen. Insbesondere besitzen die äußeren Begrenzungsflächen 12, 13 des Chipträgers 5 im Querschnitt gesehen einen im wesentlichen umgekehrten V-förmigen Verlauf, bzw. dachförmig gestalteten Verlauf, derart, daß die Spitze des umgekehrten V mittig angeordnet ist, wobei der größte Abstand an dieser Stelle zur Leiterplatte eine Wert von etwa 0,1 mm bis etwa 0,5 mm besitzt. Weiterhin ist vorgesehen, daß die den Chipträger 5 durchsetzenden und elektrisch mit dem Halbleiterchip 6 verbundenen Elektrodenanschlüsse 7 in der Form von nach wenigstens zwei Seiten des Chipträgers 5 herausgeführten Anschlußbeinchen ausgebildet sind, die zu kurzen schwingenförmigen Anschlußstummeln 17 gebogen und geschnitten sind. Eine solche Anordnung gewährleistet eine geringste Bauhöhe des Sensorbauelementes. Weiterhin sind die Biegungen 18 der Anschlußbeinchen vollständig innerhalb der Seitenteile 10, 11 des Chipträgers 5 aufgenommen, was den Vorteil besitzt, daß das Gehäuse in seinen Abmessungen nochmals verkleinert, die Größe des Leadframe verkleinert ist, und im übrigen die Kriechwege für korrosive Medien erheblich verlängert und somit eine Durchsetzung mit Chemikalien reduziert wird. Darüber hinaus ermöglicht eine solche Anordnung eine mechanische Verankerung des Leadframe bzw. der Elektrodenanschlüsse 7 innerhalb des Gehäuses des Bauteiles und damit eine zusätzliche Erhöhung der mechanischen Stabilität insgesamt. Weiterhin besitzen die aus den Seitenteilen 10, 11 des Chipträgers 5 ragenden Enden 8 der Anschlußbeinchen gegenüber der Bestückungsoberfläche 2 der Leiterplatte 3 eine geringfügige Neigung dergestalt, daß die der Bestückungsoberfläche 2 zugewandte äußerste Kante 19 des Endes 8 der Anschlußbeinchen einen Abstand von etwa 0,1 mm zu der strichliert dargestellten Hilfsebene 20 besitzt. Durch diese Anordnung wird gewährleistet, daß ein Kontakt des Bauelementes mit der Bestükkungsoberfläche 2 der Leiterplatte 3 nur durch die äußersten Enden 8 der Anschlußbeinchen gegeben ist, was zusammen mit der dargestellten, günstigen Gehäuseanordnung, bei dem der Unterteil von der Leiterplatte abgehoben ausgebildet ist und das Gehäuse wie dargestellt in Dachform ausgebildet ist, den möglichen Durchbiegungen der Leiterplatte 3 Rechnung getragen wird, und darüber hinaus Probleme bei der Bestückung des Bauelementes auf der Leiterplatte 3, sowie beim späteren Einsatz der Leiterplatte 3 vermieden werden. In vorteilhafter Weise kann hierbei ein bislang bei der Bestückung erforderliches Einstellen vermittels sogenannter Trimm- und Formwerkzeugen entfallen, und gleichzeitig den vorgegebenen Anforderungen an den einzuhaltenden Bodenabstand Rechnung getragen werden. Die Bestückung ist günstiger durchzuführen, da eine gute Adhäsion des Bestückklebers gewährleistet ist, und darüber hinaus werden mögliche Toleranzen der Leiterplatte 3 im Hinblick auf Durchbiegungen ausgeglichen, und es wird Verspannungen thermischer und/oder mechanischer Art entgegengewirkt, da ein Kontakt mit der Leiterplatte 3 nur durch die Anschlußbeinchen gegeben ist.

Für die elektrische Verbindung des auf dem Halbleiterchip 6 integriert ausgebildeten Drucksensors bzw. der diesem zugeordneten elektronischen Schaltung mit den Elektrodenanschlüssen 7 kann wie dargestellt ein Drahtkontaktierverfahren zum Einsatz gelangen, bei dem Bonddrähte 21 auf metallischen Chipanschlußstellen 21a auf dem Chip befestigt und an das entsprechend zu verbindende Elektrodenbeinchen gezogen werden. Darüber hinaus kann für diese elektrische Verbindung auch eine sogenannte Spider-Kontaktierung Verwendung finden, bei der anstelle von Bonddrähten eine elektrisch leitende Systemträgerplatte bzw. ein sogenanntes Leadframe zum Einsatz gelangt.

Der auf dem Halbleiterchip 6 aus Silizium integrierte Drucksensor stellt einen sogenannten piezoresistiven Sensor dar, bei dem eine in der Oberfläche des Chips 6 nach Methoden der Mikromechanik gefertigte dünne Silizium-Membran vorgesehen ist, die elektrisch mit druckabhängigen Widerständen gekoppelt ist, welche gleichfalls im Silizium-Substrat ausgebildet sind und in an sich bekannter Weise in einer Brückenschaltung geschaltet sind. Gleichfalls im Halbleiterchip 6 integriert ist eine dem Sensor zugeordnete Schaltung, die der Signalaufbereitung (Verstärkung und Korrektur), aber auch einem Abgleich und Kompensation des Sensors dient. Gegenüber sonstigen Bauformen eignen sich solche, der Erfindung zugrunde liegenden Halbleiter-Drucksensoren vornehmlich für solche Anwendungen, bei denen es auf eine geringste Baugröße ankommt, also beispielsweise bei Druckmessungen im Kraftfahrzeugbereich, beispielsweise bei der Messung von Bremsdrücken, Reifendrükken, Brennraumdrücken und dergleichen. Neben Halbleiter-Drucksensoren, die nach dem Prinzip der piezoresistiven Druckmessung arbeiten, sind darüber hinaus auch solche verwendbar, die mit kapazitiven Meßprinzipien arbeiten.

Bei dem in Figur 1 dargestellten Ausführungsbeispiel ist der Chipträger 5 an seiner der Bestückungsoberfläche 2 der Leiterplatte 3 abgewandten Seite 22 einseitig offen ausgebildet, und besitzt an den die Öffnung 23 begrenzenden oberen Randbereichen 24, 25 ein Stützmittel 26 für eine formschlüssig mechanische, spielfreie Verbindung mit einem Haltemittel eines auf den Chipträger 5 aufsetzbaren (nicht näher dargestellten) Anschlußstückes derart, daß beim Aufsetzen des Anschlußstükkes auf den Chipträger 5 das Haltemittel und das Stützmittel 26 wechselweise in Eingriff gelangen. Zu diesem Zweck besitzt das Stützmittel 26 des Chipträgers 5 an seinem Außenumfang eine umlaufende und das Haltemittel des Anschlußstückes abstützende Widerlagerfläche 29. Diese kann wie dargestellt in der Form einer am Randbereich des Chipträgers 5 umlaufend ausgebildeten Nut 30 ausgebildet sein, in welche eine am Außenumfang des Anschlußstückes geformte Feder wenigstens teilweise eingreift.

Der Chipträger 5 ist mit einem den Halbleiterchip 6 vollständig überdeckenden, fließfähigen Füllmittel 32 befüllt, welches insbesondere ein Gel darstellt, welches Drücke nahezu verzögerungsfrei sowie fehlerfrei auf den Halbleiterdrucksensor überträgt. Das Gel dient zum einen dazu, den empfindlichen Drucksensorchip 6 und die weiteren, insbesondere metallischen Bestandteile des elektronischen Bauelementes, insbesondere die Bonddrähte 21, die Anschlußbeinchen 7 bzw. das Leadframe vor Umwelteinflüssen, aber auch Berührungen mit dem zu messenden Medium 33 zu schützen, und auf diese Weise eine Kontamination des Bauteiles durch Ionen oder andere schädliche Bestandteile des Mediums 33, oder die Gefahr einer Korrosion aufgrund von Umwelteinflüssen oder des Mediums 33 zu verhindern. Darüber hinaus dient das Gel 32 als Füllmaterial, um das Totvolumen zwischen dem Sensor-Bauelement und dem aufgesetzten Anschlußstück möglichst gering zu halten, um Verfälschungen bzw. zeitliche Verzögerungen bei der Messung des Druckes zu vermeiden. Zur weiteren Trennung des zu messenden Mediums von dem Halbleiterchip 6 bzw. den korrosionsgefährdeten Bestandteilen des elektronischen Bauelementes ist des weiteren vorgesehen, daß die dem Chipträger 5 zugewandte Seite des Anschlußstückes mit einer elastischen Membran verschlossen ist. Die Membran ist in der Lage, den Druckimpuls des an den Sensor herangeführten Mediums ohne wesentliche Verfälschung bzw. zeitliche Verzögerung weiterzugeben, verhindert jedoch die Gefahr der Kontamination eines gefährdeten Bestandteiles durch Ionen oder andere schädliche Teile des Mediums.

Die Seitenwandungen 24, 25 des einseitig offenen Chipträgers 5 können des weiteren mit einer auf der Innenseite durchgehend angeordneten Flußstopkante 36 ausgestattet sein. In diesem Fall ist die Innenseite des Chipträgers 5 lediglich bis zur Höhe der Flußstopkante 36 mit dem Gel 32 aufgefüllt. Diese Flußstopkante 36 ermöglicht einen definierten Stop der Kapillarkräfte des adhäsiven Gels 32 und verhindert somit aufgrund von Kapillarkräften ein unerwünschtes Hochsteigen des Gels 32 über die Gehäuseränder hinaus.

## Patentansprüche

1. Auf der Bestückungsoberfläche (2) einer Leiterplatte (3) montierbares Drucksensor-Bauelement (1) mit einem eine annähernd ebene Chipträgerfläche (4) aufweisenden Chipträger (5), auf welcher Chipträgerfläche (4) ein Halbleiterchip (6) mit einem Drucksensor befestigt ist, und mit den Chipträger (5) durchsetzenden und elektrisch mit dem Halbleiterchip (6) verbundenen Elektrodenanschlüssen (7) mit einer oberflächenmontierbaren Anordnung, wobei
der aus elektrisch isolierendem Material hergestellte Chipträger (5) mit einem den Halbleiterchip (6) vollständig überdeckenden, fließfähigen Füllmittel (32) befüllt ist und ein gegenüber der Bestückungsoberfläche (2) der Leiterplatte (3) abgehobenes Unterteil (9) und zu beiden Seiten des Unterteiles (9) angeordnete Seitenteile (10, 10a, 11, 11a) aufweist.

2. Drucksensor-Bauelement nach Anspruch 1, wobei der Chipträger (5) an seiner der Bestückungsoberfläche (2) der Leiterplatte (3) abgewandten Seite (22) einseitig offen ausgebildet ist und die Seitenwandungen des Chipträgers (5) mit einer auf der Innenseite durchgehend angeordneten Flußstopkante (36) ausgestattet sind.

3. Drucksensor-Bauelement nach Anspruch 1 oder 2, wobei das fließfähige Füllmittel (32) des weiteren die gegenüber Korrosion anfälligen, insbesondere metallischen Bauteile des Drucksensor-Bauelementes (1) wie insbesondere Verbindungsdrähte, Stützträger für den Halbleiterchip (6) und dergleichen umgibt.

4. Drucksensor-Bauelement nach einem der Ansprüche 1 bis 3, wobei das fließfähige Füllmittel (32) ein Gel darstellt.

5. Drucksensor-Bauelement nach einem der Ansprüche 1 bis 4, **dadurch gekennzeichnet, daß** die den Chipträger (5) durchsetzenden und elektrisch mit dem Halbleiterchip (6) verbundenen Elektrodenanschlüssen (7) in der Form von nach wenigstens einer Seite des Chipträgers (5) herausgeführten Anschlußbeinchen ausgebildet sind, die zu kurzen schwingenförmigen Anschlußstummeln (17) gebogen und geschnitten sind.

6. Drucksensor-Bauelement nach einem der Ansprüche 1 bis 5, **dadurch gekennzeichnet, daß** der Chipträger (5) einstückig hergestellt ist.

7. Drucksensor-Bauelement nach einem der Ansprüche 1 bis 6, **dadurch gekennzeichnet, daß** die Biegungen der Anschlußbeinchen innerhalb der Seitenteile (10, 10a, 11, 11a) des Chipträgers (5) aufgenommen sind.

8. Drucksensor-Bauelement nach Anspruch 6 oder 7, **dadurch gekennzeichnet, daß** die aus den Seitenteilen (10, 10a, 11, 11a) des Chipträgers (5) ragenden Enden der Anschlußbeinchen gegenüber der Bestückungsoberfläche (2) der Leiterplatte (3) eine geringfügige Neigung besitzen.

9. Drucksensor-Bauelement nach einem der Ansprüche 1 bis 8, **dadurch gekennzeichnet, daß** die der Bestückungsoberfläche (2) der Leiterplatte (3) zugewandten äußeren Begrenzungsflächen (12, 13) des Chipträgers (5) im Querschnitt des Chipträgers (5) einen im wesentlichen umgekehrten V-förmigen Verlauf besitzen.

10. Drucksensor-Bauelement nach einem der Ansprüche 1 bis 9, **dadurch gekennzeichnet, daß** der größte Abstand der der Bestückungsoberfläche (2) zugewandten äußeren Begrenzungsflächen (12, 13) des Chipträgers (5) zur Leiterplatte (3) einen Wert von etwa 0,1 bis etwa 0,5 mm besitzt.

11. Drucksensor-Bauelement nach einem der Ansprüche 1 bis 10, **dadurch gekennzeichnet, daß** der Chipträger (5) aus einem Thermoplastkunststoffmaterial hergestellt ist.

12. Drucksensor-Bauelement nach einem der Ansprüche 1 bis 11, **dadurch gekennzeichnet, daß** der Drucksensor einen piezoresistiven oder einen kapazitiven Drucksensor darstellt.

## Claims

1. Pressure sensor component (1), which can be mounted on the component surface (2) of a printed circuit board (3), comprising a chip carrier (5) which has an approximately flat chip carrier surface (4) on which chip carrier surface (4) a semiconductor chip (6) with a pressure sensor is fastened, and comprising electrode connections (7) with a surface-mountable arrangement, which electrode connections penetrate the chip carrier (5) and are electrically connected to the semiconductor chip (6), in which the chip carrier (5), which is produced from electrically insulating material, is filled with a flowable filler (32) completely covering the semiconductor chip (6), and has a lower part (9), which is lifted with respect to the component surface (2) of the printed circuit board (3), and has lateral parts (10, 10a, 11, 11a) arranged on both sides of the lower part (9).

2. Pressure sensor component according to Claim 1, in which the chip carrier (5) is of unilaterally open construction on its side (22) averted from the component surface (2) of the printed circuit board (3), and the side walls of the chip carrier (5) are fitted with a flow-stopping edge (36) continuously arranged on the inner side.

3. Pressure sensor component according to Claim 1 or 2, in which the flowable filler (32) further surrounds the structural elements of the pressure sensor component (1), which are susceptible to corrosion and are, in particular, metallic, such as, in particular, connecting wires, supporting carriers for the semiconductor chip (6) and the like.

4. Pressure sensor component according to one of Claims 1 to 3, in which the flowable filler (32) constitutes a gel.

5. Pressure sensor component according to one of Claims 1 to 4, **characterized in that** the electrode connections (7), which penetrate the chip carrier (5) and are electrically connected to the semiconductor chip (6), are constructed in the form of pins which are led out of at least one side of the chip carrier (5) and are bent to form short rocker-shaped connecting stubs (17) and cut.

6. Pressure sensor component according to one of Claims 1 to 5, **characterized in that** the chip carrier (5) is produced in one piece.

7. Pressure sensor component according to one of Claims 1 to 6, **characterized in that** the bends of the pins are accommodated inside the side parts (10, 10a, 11, 11a) of the chip carrier (5).

8. Pressure sensor component according to Claim 6 or 7, **characterized in that** the ends, projecting from the side parts (10, 10a, 11, 11a) of the chip carrier (5), of the pins have a slight inclination with respect to the component surface (2) of the printed circuit board (3).

9. Pressure sensor component according to one of Claims 1 to 8, **characterized in that** the outer boundary surfaces (12, 13), facing the component surface (2) of the printed circuit board (3), of the chip carrier (5) have an essentially inverted V-shaped course in the cross section of the chip carrier (5).

10. Pressure sensor component according to one of Claims 1 to 9, **characterized in that** the largest spacing of the outer boundary surfaces (12, 13), facing the component surface (2), of the chip carrier (5) from the printed circuit board (3) has a value of approximately 0.1 to approximately 0.5 mm.

11. Pressure sensor component according to one of Claims 1 to 10, **characterized in that** the chip carrier (5) is produced from a thermoplastic material.

12. Pressure sensor component according to one of Claims 1 to 11, **characterized in that** the pressure sensor constitutes a piezoresistive or a capacitive pressure sensor.

## Revendications

1. Composant (1) à capteur de pression pouvant être monté sur la surface (2) d'implantation d'une plaquette (3) à circuit imprimé, comprenant un support (5) de puce ayant une surface (4) de support de puce approximativement plane sur laquelle est fixée une puce (6) à semi-conducteur ayant un capteur de pression, et des bornes (7) d'électrodes traversant le support (5) de puce et reliées électriquement à la puce (6) à semi-conducteur en ayant un agencement qui peut être monté en surface, le support (5) de puce en un matériau isolant du point de vue électrique étant empli d'un agent (32) de remplissage, susceptible de s'écouler, recouvrant entièrement la puce (6) à semi-conducteur et comportant une partie (9) inférieure soulevée par rapport à la surface (2) d'implantation de la plaquette (3) à circuit imprimé et des parties (10, 10a, 11, 11a) latérales disposées de part et d'autre de la partie (9) inférieure.

2. Composant à capteur de pression suivant la revendication 1, dans lequel le support (5) de puce est ouvert d'un côté sur son côté (22) éloigné de la surface (2) d'implantation de la plaquette (3) à circuit imprimé et les parois latérales du support (5) de puce sont munies d'un bord (36) d'arrêt de flux continu jusqu'à la face intérieure.

3. Composant à capteur de pression suivant la revendication 1 ou 2, dans lequel l'agent (32) de remplissage qui est susceptible de s'écouler, entoure en outre les composants sensibles à la corrosion, notamment métalliques, du composant (1) à capteur de pression, comme notamment les fils de liaison, les supports d'appui de la puce (6) à semi-conducteur et analogues.

4. Composant à capteur de pression suivant l'une des revendications 1 à 3, dans lequel l'agent (32) de remplissage qui est susceptible de s'écouler constitue un gel.

5. Composant à capteur de pression suivant l'une des revendications 1 à 4, **caractérisé en ce que** les bornes (7) d'électrodes traversant le support (5) de puce et reliées électriquement à la puce (6) à semi-conducteur sont constituées sous la forme de pattes de raccordement sortant vers au moins l'une des faces du support (5) de puce et coudées ou découpées en tronçons (17) de raccordement courts, susceptibles d'osciller.

6. Composant à capteur de pression suivant l'une des revendications 1 à 5, **caractérisé en ce que** le support (5) de puce est d'un seul tenant.

7. Composant à capteur de pression suivant l'une des revendications 1 à 6, **caractérisé en ce que** les courbures des pattes de raccordement sont logées dans les parties (10, 10a, 11, 11a) latérales du support (5) de puce.

8. Composant à capteur de pression suivant la revendication 6 ou 7, **caractérisé en ce que** les extrémités des pattes de raccordement, qui font saillie des parties (10, 10a, 11, 11a) latérales du support (5) de puce, sont légèrement inclinées par rapport à la surface (2) d'implantation de la plaquette (3) à circuit imprimé.

9. Composant à capteur de pression suivant l'une des revendications 1 à 8, **caractérisé en ce que** les surfaces (12, 13) extérieures de délimitation du support (5) de puce, qui sont tournées vers la surface (2) d'implantation de la plaquette (3) à circuit imprimé, ont, suivant la section transversale du support (5) de puce, une courbe sensiblement en forme de V inversé.

10. Composant à capteur de pression suivant l'une des revendications 1 à 9, **caractérisé en ce que** la distance la plus grande à la plaquette (3) à circuit imprimé des surfaces (12, 13) extérieures de délimitation du support (5) de puce, qui sont tournées vers la surface (2) d'implantation, a une valeur comprise entre environ 0,1 et environ 0,5 mm.

11. Composant à capteur de pression suivant l'une des revendications 1 à 10, **caractérisé en ce que** le support (5) de puce est en une matière plastique thermoplastique.

12. Composant à capteur de pression suivant l'une des revendications 1 à 11, **caractérisé en ce que** le capteur de pression est un capteur de pression piézorésistif ou un capteur de pression capacitif.
